# EUROPÄISCHE PATENTSCHRIFT

(11) **EP 4 107 495 B1**
(45) Veröffentlichungstag und Bekanntmachung des Hinweises auf die Patenterteilung: **25.10.2023**
(21) Anmeldenummer: 21708944.0
(22) Anmeldetag: 17.02.2021
(51) Int. Cl.: G01G 21/28

(54) **GRAVIMETRISCHE MESSVORRICHTUNG**
GRAVIMETRIC MEASURING APPARATUS
APPAREIL DE MESURE GRAVIMÉTRIQUE

(30) Priorität: 20.02.2020 DE 102020104518
(43) Veröffentlichungstag der Anmeldung: 28.12.2022
(73) Patentinhaber: Sartorius Lab Instruments GmbH & Co. KG, 37079 Göttingen (DE)
(72) Erfinder: EMMERMANN, Bettina, 37077 Göttingen (DE); BERGER, Alexander, 37181 Hardegsen (DE); FELDMANN, Reinhold, 37434 Obernfeld (DE); GRAF, Winfried, 37085 Göttingen (DE)
(74) Vertreter: Novagraaf International SA
(86) Internationale Anmeldenummer: PCT/EP2021/053912
(87) Internationale Veröffentlichungsnummer: WO 2021/165335

(56) Entgegenhaltungen:
- EP-A1- 3 557 199
- EP-A1- 3 557 201
- WO-A1-2020/161103

## Beschreibung

### Gebiet der Erfindung

Die Erfindung bezieht sich auf eine gravimetrische Messvorrichtung, umfassend einen Wägeraum mit einer vertikalen Wägeraumwand, die als eine Trägerstruktur mit wägeraumseitig daran lösbar fixierten, jeweils eine wägeraumseitige Modul-Vorderwand umfassenden, die Trägerstruktur wenigstens bereichsweise abdeckenden Abdeckmodulen ausgebildet ist,
wobei die Abdeckmodule nach trägerstrukturseitig gerichtete Verriegelungs-Ausleger aufweisen.

### Stand der Technik

Gattungsgemäße gravimetrische Messvorrichtungen sind bekannt aus der EP 3 557 199 A1.

Diese Druckschrift offenbart eine Waage mit einem ein mechanisches Wägesystem sowie eine damit gekoppelte Wägesensorik umschließenden Gehäuse und einem daran angrenzenden Wägeraum. In den Wägeraum hinein ragt ein Lastaufnehmer des Wägesystems, auf welchem das zu wiegende Wägegut positionierbar ist. Der Wägeraum ist unten von einem horizontalen Wägeraumboden und oben von einem ebenfalls horizontalen Wägeraumdeckel begrenzt. Mit dem Gehäuse teilt sich der Wägeraum eine gemeinsame, vertikale Trennwand, die zugleich als Vorderwand des Gehäuses und als Rückwand des Wägeraums dient. Die übrigen drei Seiten des Wägeraums sind durch einen bereichsweise öffenbaren Windschutz geschlossen. Der Fachmann wird verstehen, dass die sich die Begriffe "horizontal" und "vertikal" im Kontext der vorliegenden Beschreibung auf die (durch die Richtung der Schwerkraft vorgegebene) Betriebsstellung der gravimetrischen Wägevorrichtung beziehen. Die genannte Druckschrift offenbart einen modularen Aufbau der Wägeraumrückwand. Insbesondere ist diese aus einer Mehrzahl von übereinander anordenbaren Wandelementen gebildet, sodass sie, je nach Wahl der Art und Anzahl der Wandelemente, in ihrer Höhe variierbar ist. Die aus solchen Wandelementen aufgebaute Wägeraumrückwand weist Ausnehmungen auf, zu deren Funktion sich in der genannten Druckschrift keine weiteren Ausführungen finden. Allerdings sind die Ausnehmungen mittels blendenartiger Abdeckmodule verschließbar. Die Abdeckmodule bestehen im Wesentlichen aus einer gewölbten Modul-Vorderwand, von der sich nach trägerstrukturseitig Rastausleger erstrecken, die im Montageendzustand mit korrespondierenden Rastelementen der Trägerstruktur verrasten. Die Abdeckmodule, insbesondere ihre Vorderwände, ergänzen einander sowie die trägerstrukturseitigen Berandungen der Ausnehmungen bündig, sodass sich im Montageendzustand eine bündige Oberfläche der Wägeraumrückwand ergibt.

Die Befestigung der Abdeckmodule an der Trägerstruktur erscheint ungünstig. Bei der Montage müssen die Rastausleger sehr präzise in schmale Kanäle der Trägerstruktur eingeführt und die Abdeckmodule sehr präzise in horizontaler Richtung eingeschoben werden. Da die eigentlichen Raststellen im Montageendzustand nicht zugänglich sind, darf die Verrastung zudem nicht zu einer sicheren Verriegelung der Abdeckmodule an der Trägerstruktur führen, da ansonsten ein erneutes Abnehmen nicht möglich wäre. Dies führt allerdings dazu, dass die Abdeckmodule durch reine Kraftanwendung abziehbar und daher auch von nicht autorisiertem Personal entfernbar sind. Die einzige "Sicherung" der Abdeckmodule besteht in einer entsprechend hohen Dimensionierung der zum Abziehen erforderlichen Kräfte. Im Kontext höchst filigraner Komponenten, wie sie insbesondere bei Präzisionswaagen regelmäßig Einsatz finden, ist jedoch die Anwendung hoher Kräfte grundsätzlich kontraindiziert.

Die EP 1 312 902 A1 offenbart eine Waage, an deren Wägeraum-Rückwand eine elektronische Zusatzeinheit, in welcher Versorgungseinheiten, bspw. eine Batterie, oder auch eine Steuerungselektronik angeordnet sein können, anbringbar ist.

Auch die US 2010/0276213 A1 offenbart eine Waage, an deren Wägeraum-Rückwand eine Steuerungselektronik angeordnet ist. Diese ist mechanisch und elektronisch mit einer über dem Lastaufnehmer angeordneten Dosierdüse verbunden, sodass die Waage insgesamt als Dosiervorrichtung nutzbar ist.

Die DE 10 2014 101 561 A1 offenbart eine gravimetrische Dosiervorrichtung mit einem im Wägeraum angeordneten Klimamessmodul. Auf Basis der damit ermittelten Klimadaten können im Rahmen des Dosiervorgangs zu mischende Komponenten außerhalb der Vorrichtung vortemperiert werden.

Die beiden nachveröffentlichten Druckschriften DE 10 2019 102 810 A1 und DE 2019 102 810 A1 offenbaren jeweils Waagen, deren Wägeraumrückwand aus einer Trägerstruktur mit Ausnehmungen besteht, die von formangepassten auswechselbaren Funktions- oder Abdeckblenden abdeckbar sind. Zu den Details einer mechanischen Fixierung der Blenden schweigen diese Druckschriften.

### Aufgabenstellung

Es ist die Aufgabe der vorliegenden Erfindung, eine verbesserte Fixierung der Abdeckmodule zur Verfügung zu stellen.

### Darlegung der Erfindung

Diese Aufgabe wird in Verbindung mit den Merkmalen des Oberbegriffs von Anspruch 1 dadurch gelöst, dass die Verriegelungs-Ausleger mit vertikal ausgerichteten Durchgangsöffnungen versehen sind, die mit korrespondierenden Öffnungen der Trägerstruktur fluchten, wobei die Abdeckmodule mittels Verriegelungs-Stangen, die die miteinander fluchtenden Durchgangsöffnungen der Abdeckmodule und der Trägerstruktur durchsetzen, an der Trägerstruktur verriegelt sind.

Bevorzugte Ausführungsformen sind Gegenstand der abhängigen Ansprüche.

Anstelle der bekannten Verrastung erfolgt die Fixierung der Abdeckmodule an der Trägerstruktur erfindungsgemäß mittels gesonderter Verriegelungselemente. Die horizontal ausgerichteten und mit senkrecht dazu, insbesondere vertikal ausgerichteten Durchbrüchen versehenen Verriegelungs-Ausleger lassen sich durch eine im Wesentlichen horizontal ausgerichtete Aufsetzbewegung mit ebenfalls vertikal ausgerichteten, korrespondierenden Öffnungen in der Trägerstruktur zur Deckung bringen. In diesem Zustand werden stangenförmige Verriegelungselemente in vertikaler Richtung durch die Paare von Durchgangsöffnungen geschoben, sodass ein horizontales Abziehen der Abdeckmodule zuverlässig unterbunden wird. Solches wird erst wieder möglich, wenn die axial (bzw. vertikal) verschieblichen Verriegelungs-Stangen wieder aus den Durchgangsöffnungs-Paaren herausgezogen werden. Dann allerdings ist das horizontale Abziehen der Abdeckmodule im Wesentlichen kräftefrei möglich. Eine verdeckte, ggf. nur mittels eines Schlüssels oder mittels Spezialwerkzeugs zugängliche Anordnung der oberen Stangenenden im Montageendzustand kann einer unbefugten Entfernung bzw. einem unbefugten Auswechseln oder Manipulieren von Abdeckmodulen oder von durch die Abdeckmodule abgedeckten Elementen entgegenwirken.

Die Fixierung der Abdeckmodule in vertikaler Richtung kann beispielsweise durch Auflage der Verriegelungs-Ausleger auf korrespondierenden Elementen der Trägerstruktur und/oder durch Auflage der Abdeckmodule aufeinander erfolgen.

Die Verriegelungs-Stangen durchsetzen die miteinander fluchtenden Öffnungen vorzugsweise formschlüssig, sodass die Abdeckmodule weitgehend spielfrei an der Trägerstruktur verriegelt sind. Bei hinreichender Tiefe der Durchgangsöffnungen wird durch einen solchen Formschluss nicht nur eine weitgehende Spielfreiheit gegenüber Bewegungen in horizontaler Richtung sondern auch eine weitgehende Kippsicherheit begründet.

Im bevorzugten Fall mehrerer vertikal übereinander gestapelter Abdeckmodule hat sich deren Vorfixierung an der Trägerstruktur mit nachfolgender, gemeinsamer Verriegelung mittels Verriegelungs-Stangen, die die vertikal übereinander positionierten Durchgangsöffnungen mehrerer, vorzugsweise sämtlicher Abdeckmodule durchgreifen, als günstig erwiesen. Zur praktischen Umsetzung wird bevorzugt, wenn die Abdeckmodule jeweils nach trägerstrukturseitig gerichtete Vorfixierungs-Ausleger mit modulseitigen Rastelementen aufweisen, welche reversibel mit korrespondieren Rastelementen der Trägerstruktur verrastet sind. Da diese Verrastungen jedoch, wie erläutert, lediglich einer temporären Vorfixierung dienen, können sie so ausgebildet werden, dass bereits sehr geringe Abzugskräfte zu ihrer Überwindung ausreichen. Die eigentliche Verriegelung, d.h. endgültige und nicht durch (beliebig hohe) Abzugskräfte überwindbare Fixierung an der Trägerstruktur erfolgt durch das Einstecken der Verriegelungs-Stangen.

Besonders bevorzugt ist es, wenn jeweils zwei Paare von miteinander verrasteten Rastelementen eine um eine horizontale, wandparallele Schwenkachse schwenkbewegliche Anlenkung des jeweiligen Abdeckmoduls an der Trägerstruktur bilden. Dies kann beispielsweise und bevorzugt dadurch erfolgen, dass die trägerstrukturseitigen Rastelemente als lateral verschiebliche, federvorgespannte Kugelelemente und die modulseitigen Rastelemente als korrespondierende Gelenkpfannen ausgebildet sind. Eine solch schwenkbewegliche Vorfixierung wird deshalb als besonders günstig angesehen, weil zu ihrer Etablierung keine hochpräzise Positionierung und Führung des Abdeckmoduls beim vorfixierenden Aufstecken auf die Trägerstruktur erforderlich ist. Vielmehr genügt beim Aufstecken ein grobes Anpeilen der trägerstrukturseitigen Rastelemente mit den modulseitigen Rastelementen. Das Einschnappen der korrespondieren Rastelemente ineinander erfolgt dennoch zuverlässig, was eine Fehlertoleranz bei der Montage und daher eine deutliche Zeitersparnis bedeutet. Eine solche Vorfixierung führt zu einer vertikal und horizontal bereits korrekten Positionierung der Abdeckmodule; lediglich ein Schwenk-Freiheitsgrad bleibt erhalten, der jedoch, wie oben bereits erläutert, durch formschlüssiges Einstecken der Verriegelungsstangen aufgehoben wird.

Denkbar ist die Ausgestaltung der Abdeckmodule als im Wesentlichen aus ihrer Modul-Vorderwand und den Verriegelungs- und ggf. den Vorfixierungs-Auslegern bestehenden Elementen. In vielen Fällen günstiger ist es jedoch, wenn die Abdeckmodule sich von der jeweiligen Modul-Vorderwand nach trägerstrukturseitig erstreckende, senkrecht zur Modul-Vorderwand ausgerichtete Modul-Randwände aufweisen. Im bevorzugten Fall von sich rings um den Rand der Modul-Vorderwand erstreckenden Modul-Randwänden weisen die Abdeckmodule im Wesentlichen eine offen kastenartige Form auf. Eine vollumfängliche Umrandung der Modul-Vorderwand mit Modul-Randwänden ist jedoch keinesfalls zwingend.

Wenn aber die Modul-Randwände zumindest eine bodenseitige untere Modul-Wand und eine dieser gegenüber angeordnete, obere Modul-Wand umfassen, ist bevorzugt vorgesehen, dass die Verriegelungs-Ausleger als am freien Rand der oberen und unteren Modul-Wand angeordnete Laschen ausgebildet sind. Diese können sich z.B. in entsprechende Schlitze in der Trägerstruktur einschieben, sodass die freien Kanten der Modul-Randwände im Übrigen an der Trägerstruktur anliegen und - zumindest im Fall der offen kastenartigen Form des Abdeckmoduls - mit der Trägerstruktur einen abgeschlossenen Hohlraum bilden.

Entsprechendes gilt auch für die Vorfixierungs-Ausleger. Im Fall nämlich, dass die Modul-Randwände zumindest zwei vertikal ausgerichtete Modul-Seitenwände umfassen, ist bevorzugt vorgesehen, dass die Vorfixierungs-Ausleger als am freien Rand der Modul-Seitenwände angeordnete Laschen ausgebildet sind.

Bei vollständiger Bestückung der Trägerstruktur mit Abdeckmodulen bilden die Modul-Vorderwände bevorzugt gemeinsam eine die gesamte Trägerstruktur abdeckende Abdeckfläche. Diese wirkt dann als die eigentliche Wägeraumbegrenzung.

Die Modul-Vorderwände bilden bevorzugt gemeinsam eine ebene Abdeckfläche.

Denkbar ist selbstverständlich, dass die Modul-Vorderwände im Montageendzustand unmittelbar an der Trägerstruktur anliegen. In diesem Fall hätten die Abdeckungen im Wesentlichen die Funktion des leicht austauschbaren bzw. reinigbaren Verschmutzungsschutzes. Bei einer Weiterbildung der Erfindung ist jedoch vorgesehen, dass wenigstens eines der Abdeckmodule einen trägerstrukturseitigen Leerraum abdeckt, in dem eine elektronische Primäreinheit angeordnet und an der Trägerstruktur fixiert ist. In diesem Fall dienen die Abdeckmodule also gezielt der Kaschierung und ggf. sogar Kapselung von elektronischen Funktionseinheiten, mit denen die Waage vorzugsweise variabel bestückt ist. So können an der Trägerstruktur geeignete Schnittstellen für besagte elektronische Primäreinheit angeordnet sein. Beispielsweise handelt es sich hierbei um elektrische, datentechnische, identifikationstechnische und/oder thermische Schnittstellenkomponenten. Die tatsächliche Ausstattung der Waage mit entsprechenden elektronischen Primäreinheiten erfolgt bedarfsweise und nach Kundenanforderungen. Die elektronischen Primäreinheiten werden sodann von den Abdeckmodulen zum Wägeraum hin abgeschirmt. Der erwähnte Leerraum kann eine Ausnehmung in der Trägerstruktur, ein Zwischenraum zwischen Trägerstruktur und Modul-Vorderwand oder eine Kombination davon sein. Er kann insbesondere, wenigstens bereichsweise, durch die weiter oben beschriebenen Modul-Randwände und/oder durch Fenster in der Trägerstruktur, die beispielsweise als ein aus Pfosten und Querstreben aufgebautes Gerüst ausgebildet ist, konstituiert sein.

Bei einer Weiterbildung dieser Ausführungsform ist vorgesehen, dass die Modul-Vorderwand des die elektronische Primäreinheit abdeckenden Abdeckmoduls eine mit dieser verbundene Sekundäreinheit trägt. Beispielsweise kann die elektronische Primäreinheit eine elektronische Schnittstelle zum Wägesensor bzw. zu der diesen steuernden Steuerelektronik enthalten und die Sekundäreinheit kann als mit dieser gekoppelte Digitalanzeige ausgebildet sein. Als weiteres Ausführungsbeispiel seien eine als Beleuchtungssteuerung ausgebildete elektronische Primäreinheit und eine als Leuchtmittel ausgebildete Sekundäreinheit genannt. Andere Ausführungsformen umfassen lonisierungseinheiten, Temperierungsmodule, Klimasensoren etc.

Alternativ oder zusätzlich ist es allerdings auch möglich, dass die Modul-Vorderwand eine passive Funktionseinheit oder eine aktive Funktionseinheit ohne vorgeschaltete, elektronische Primäreinheit an der Trägerstruktur trägt. Allgemein lassen sich die diesbezüglich möglichen Ausführungsformen dadurch zusammenfassen, dass die Modul-Vorderwand wenigstens eines Abdeckmoduls eine in den Wägeraum ragende Funktionseinheit trägt.

Weitere Merkmale und Vorteile der Erfindung ergeben sich aus der nachfolgenden speziellen Beschreibung und den Zeichnungen.

### Kurzbeschreibung der Zeichnungen

Es zeigen:
- Figur 1:: ein Basiselement einer erfindungsgemäßen Messvorrichtung mit einer Trägerstruktur für eine Wägeraumrückwand,
- Figur 2:: das Basiselement von Figur 1 mit an der Trägerstruktur vorfixierten Abdeckmodulen,
- Figur 3:: eine Detaildarstellung zur Illustration der Vorfixierung,
- Figur 4:: das Basiselement von Figur 2 mit verriegelten Abdeckmodulen,
- Figur 5:: eine Schnittdarstellung durch das Basiselement von Figur 4 im Bereich einer Verriegelungsstange,
- Figur 6:: das Basiselement von Figur 4 mit zusätzlich eingehängtem Tablett sowie
- Figur 7:: eine Detaildarstellung zur Illustration der Einhängung des Tabletts.

### Beschreibung bevorzugter Ausführungsformen

Gleiche Bezugszeichen in den Figuren deuten auf gleiche oder analoge Elemente hin.

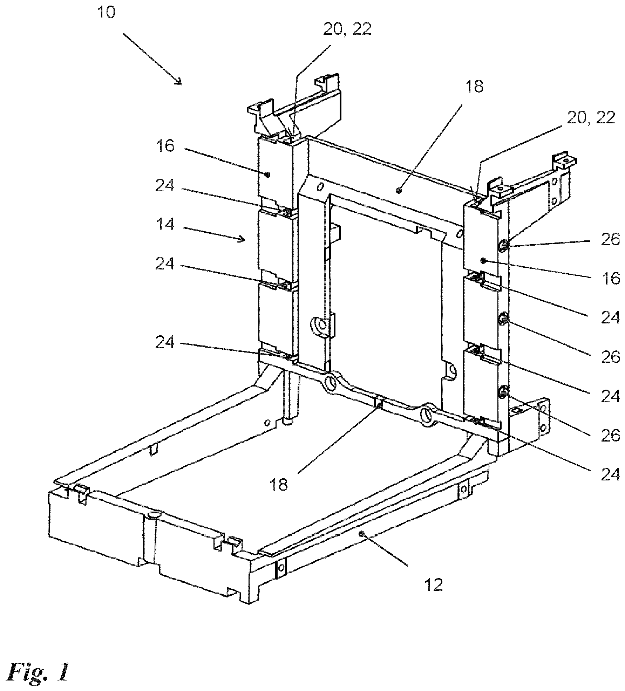

Figur 1 zeigt ein als Basiselement 10 bezeichnetes Element einer Basis einer Ausführungsform einer erfindungsgemäßen gravimetrischen Messvorrichtung. Das Basiselement 10 umfasst einen im Rahmen der vorliegenden Erfindung nicht weiter relevanten Bodenträger 12, auf dem im Montageendzustand der Wägeraumboden fixiert ist. Im Kontext der vorliegenden Erfindung relevant ist jedoch der vertikale Teil des Basiselementes 10, der eine Trägerstruktur 14 als Bestandteil einer erfindungsgemäß ausgebildeten Wägeraumrückwand darstellt. Die Trägerstruktur 14 umfasst bei der dargestellten Ausführungsform zwei vertikale Pfosten 16, die mittels zweier horizontaler Streben 18 miteinander verbunden sind. Die Pfosten 16 weisen jeweils einen senkrechten Führungskanal 20 auf, dessen Innenraum über obere Einführöffnungen 22 sowie über seitliche Schlitze 24 zugänglich ist.

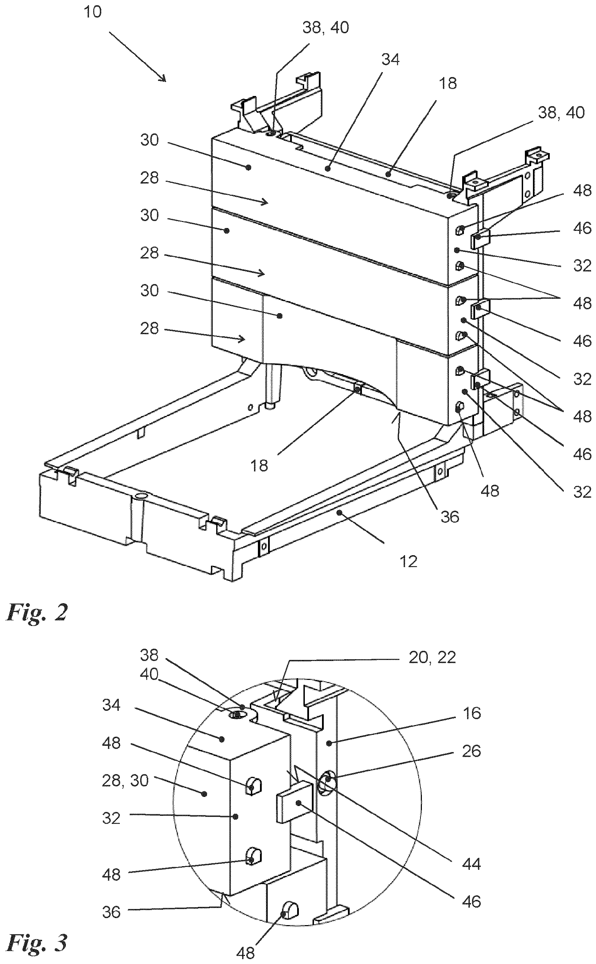

Die lateralen Außenseiten der Pfosten 16 sind mit Rastelementen 26 versehen, auf die weiter unten, insbesondere im Kontext von Figur 3, noch näher einzugehen ist.

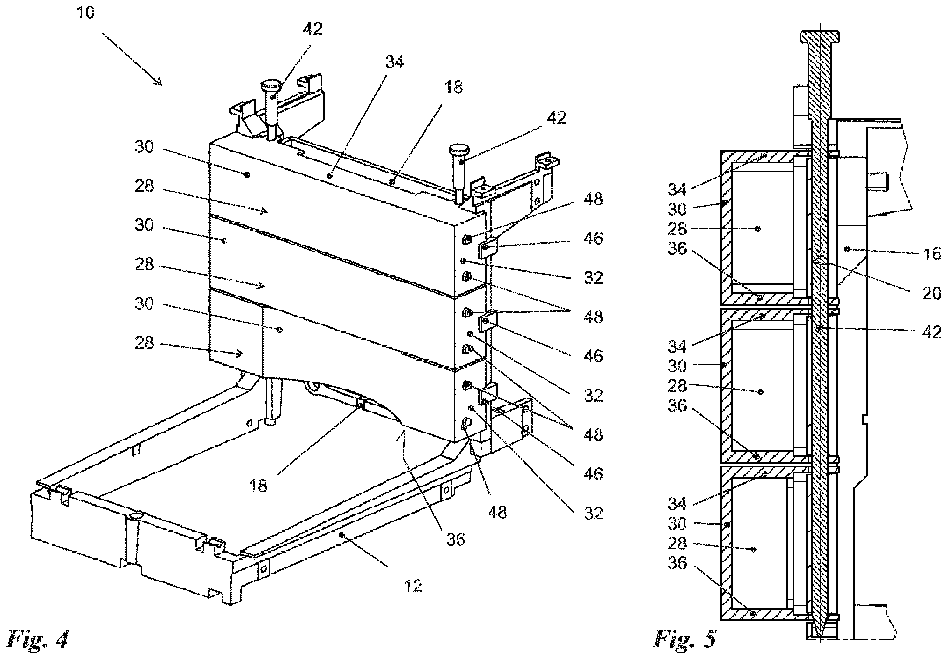

Figur 2 zeigt das Basiselement 10 von Figur 1 mit vorfixierten Abdeckmodulen 28. Figur 3 zeigt eine Detaildarstellung zur Illustration der Vorfixierung des obersten Abdeckmoduls 28. Die Figuren 4 und 5 zeigen dasselbe Basiselement mit daran verriegelten Abdeckmodulen. Die Figuren sollen nachfolgend gemeinsam diskutiert werden.

Bei der dargestellten Ausführungsform sind die Abdeckmodule 28 offen kastenförmig ausgebildet und weisen hierzu eine Modul-Vorderwand 30, Modul-Seitenwände 32 und jeweils eine obere Modulwand 34 sowie eine untere Modulwand 36 auf. An ihren trägerstrukturseitigen Rändern weisen die oberen und unteren Modulwände jeweils zwei laschenförmig ausgebildete Verriegelungs-Ausleger 38 mit je einer vertikalen Durchgangsbohrung 40 auf. In der dargestellten Vorfixierungslage der Abdeckmodule 28 fluchten die Durchgangsbohrungen 40 mit den Einführöffnungen 22 der Führungskanäle 20. Die in Figur 2 nicht sichtbaren Verriegelungsausleger 38 an der unteren Modulwand 36 des obersten Abdeckmoduls 28 sowie an den oberen und unteren Modulwänden 34, 36 der unteren Abdeckmodule 28 greifen in die seitlichen Schlitze 24 der Pfosten 16 ein, sodass auch ihre Durchgangsbohrungen 40 mit den Führungskanälen 20 fluchten. Zur Verriegelung der Abdeckmodule 28 an der Trägerstruktur 14 werden, wie in den Figuren 4 und 5 erkennbar, Verriegelungs-Stangen 42 durch die Durchgangsbohrungen 40 und in die Führungskanäle 22 eingeschoben. Die Abdeckmodule 28 sind auf diese Weise zuverlässig gegen ein Abziehen gesichert.

Bei der dargestellten Ausführungsform sind die Abdeckmodule 28 jedoch bereits ohne die Verriegelungs-Stangen 42 an der Trägerstruktur 14 vorfixiert. Hierzu sind trägerstrukturseitige Rastelemente 26 mit modulseitigen Rastelementen 44 verrastet. Die trägersturkturseitigen Rastelemente 26 sind als nach lateral außen vorstehende mit Halbkugelköpfen versehene Zapfen ausgebildet, die in entsprechenden Lagerkanälen nach lateral außen federvorgespannt gelagert sind. Die modulseitigen Rastelemente 44 sind in nicht näher dargestellter Weise korrespondierend gelenkpfannenartig ausgebildet und sitzen an den Innenseiten von Vorfixierungs-Auslegern 46, die sich von den Modul-Seitenwänden 32 der Abdeckmodule 28 nach trägerstrukturseitig erstrecken. Beim Aufstecken der Abdeckmodule 28 werden die Halbkugelkopfzapfen von den Vorfixierungs-Auslegern 46 entgegen ihrer Federkraft nach lateral innen gedrückt, um in der Aufsteck-Endstellung in besagte Kugelpfannen zu schnappen. Damit ist eine lediglich einen Schwenkfreiheitsgrad zulassende Vorfixierung gewährleistet.

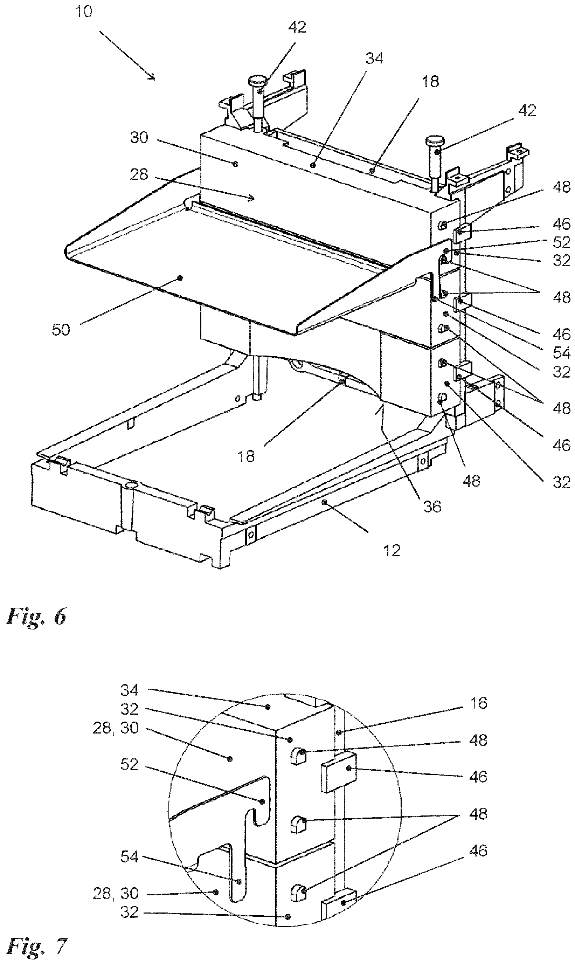

Die Figuren 6 und 7 illustrieren eine besonders vorteilhafte Weiterbildung der erfindungsgemäßen Abdeckmodule 28. Diese tragen bei der gezeigten Ausführungsform an ihren Modul-Seitenwänden 32 lateral vorstehende Vorsprünge 48 mit abgerundeter Oberkante. Die Seiten- und Unterkanten der Vorsprünge 48 sind bei der gezeigten Ausführungform jeweils gerade ausgestaltet. Die Vorsprünge 48 lassen sich, wie insbesondere in Figur 6 erkennbar, als Halterung für in den Wägeraum hineinragende Zusatzmodule, bei der gezeigten Ausführungsform ein in den Wägeraum ragendes Tablett 50, nutzen. Das Tablett 50 weißt hierzu seitliche Haken 52 auf, die formschlüssig über die Vorsprünge 48 gehängt werden können. Um ein schwerkraftgetriebenes Wegklappen des Tabletts 50 nach unten zu vermeiden, weisen die Tabletts zusätzliche Stützhebel 54 auf, die sich an der wägeraumseitigen Seitenkante des nächst tieferen Vorsprungs 48 abstützen. Details dieser Konstruktion sind vergrößert in Figur 7 dargestellt.

Natürlich stellen die in der speziellen Beschreibung diskutierten und in den Figuren gezeigten Ausführungsformen nur illustrative Ausführungsbeispiele der vorliegenden Erfindung dar. Dem Fachmann ist im Lichte der hiesigen Offenbarung ein breites Spektrum an Variationsmöglichkeiten an die Hand gegeben. Beispielsweise ist es denkbar, alternativ oder zusätzlich zu dem beschriebenen Tablett 50 auch andere Zusatzmodule, wie beispielsweise eine Dosierhilfe, Dichtebestimmungszubehör etc., zu installieren.

### Bezugszeichenliste

- 10: Basiselement
- 12: Bodenträger
- 14: Trägerstruktur
- 16: Pfosten
- 18: Strebe
- 20: Führungskanal
- 22: Einführöffnung
- 24: Schlitz
- 26: trägerstrukturseitiges Rastelement
- 28: Abdeckmodul
- 30: Modul-Vorderwand
- 32: Modul-Seitenwand
- 34: obere Modulwand
- 36: untere Modulwand
- 38: Verriegelungs-Ausleger
- 40: Durchgangsbohrung
- 42: Verriegelungs-Stange
- 44: modulseitiges Rastelement
- 46: Vorfixierungs-Ausleger
- 48: Vorsprung
- 50: Tablett
- 52: Haken
- 54: Stützhebel

## Patentansprüche

1. Gravimetrische Messvorrichtung, umfassend einen Wägeraum mit einer vertikalen Wägeraumwand, die als eine Trägerstruktur (14) mit wägeraumseitig daran lösbar fixierten, jeweils eine wägeraumseitige Modul-Vorderwand (30) umfassenden, die Trägerstruktur (14) wenigstens bereichsweise abdeckenden Abdeckmodulen (28) ausgebildet ist,
wobei die Abdeckmodule (28) nach trägerstrukturseitig gerichtete Verriegelungs-Ausleger (38) aufweisen,
**dadurch gekennzeichnet,**
**dass** die Verriegelungs-Ausleger (38) mit vertikal ausgerichteten Durchgangsöffnungen (40) versehen sind, die mit korrespondierenden Öffnungen (20, 22) der Trägerstruktur (14) fluchten, wobei die Abdeckmodule (28) mittels Verriegelungs-Stangen (42), die die miteinander fluchtenden Öffnungen (40; 20, 22) der Abdeckmodule (28) und der Trägerstruktur (14) durchsetzen, an der Trägerstruktur (14) verriegelt sind.

2. Gravimetrische Messvorrichtung nach Anspruch 1,
**dadurch gekennzeichnet,**
**dass** die Verriegelungs-Stangen (42) die miteinander fluchtenden Öffnungen (40; 20, 22) formschlüssig durchsetzen.

3. Gravimetrische Messvorrichtung nach einem der vorangehenden Ansprüche,
**dadurch gekennzeichnet,**
**dass** die Abdeckmodule (28) jeweils nach trägerstrukturseitig gerichtete Vorfixierungs-Ausleger (46) mit modulseitigen Rastelementen (44) aufweisen, welche reversibel mit korrespondierenden Rastelementen (26) der Trägerstruktur verrastet sind.

4. Gravimetrische Messvorrichtung nach Anspruch 3,
**dadurch gekennzeichnet,**
**dass** jeweils zwei Paare von miteinander verrasteten Rastelementen (26, 44) eine um eine horizontale, wandparallele Schwenkachse schwenkbewegliche Anlenkung des jeweiligen Abdeckmoduls (28) an der Trägerstruktur (44) bilden.

5. Gravimetrische Messvorrichtung nach einem der Ansprüche 3 bis 4,
**dadurch gekennzeichnet,**
**dass** die trägerstrukturseitigen Rastelemente (26) als lateral verschiebliche, federvorgepannte Kugelelemente und die modulseitigen Rastelemente (44) als korrespondierende Gelenkpfannen ausgebildet sind.

6. Gravimetrische Messvorrichtung nach einem der vorangehenden Ansprüche,
**dadurch gekennzeichnet,**
**dass** die Abdeckmodule (28) sich von der jeweiligen Modul-Vorderwand (30) nach trägerstrukturseitig erstreckende, senkrecht zur Modul-Vorderwand (30) ausgerichtete Modul-Randwände (32, 34, 36) aufweisen.

7. Gravimetrische Messvorrichtung nach Anspruch 6,
**dadurch gekennzeichnet,**
**dass** die Modul-Randwände (32, 34, 36) eine bodenseitige, untere Modul-Wand (36) und eine dieser gegenüber angeordnete, oberen Modul-Wand (34) umfassen und die Verriegelungs-Ausleger (38) als am freien Rand der oberen und unteren Modul-Wand (34, 36) angeordnete Laschen ausgebildet sind.

8. Gravimetrische Messvorrichtung nach einem der Ansprüche 6 bis 7,
**dadurch gekennzeichnet,**
**dass** die Modul-Randwände (32, 34, 36) zwei vertikal ausgerichtete Modul-Seitenwände (32) umfassen und die Vorfixierungs-Ausleger (46) als am freien Rand der Modul-Seitenwände (32) angeordnete Laschen ausgebildet sind.

9. Gravimetrische Messvorrichtung nach einem der vorangehenden Ansprüche,
**dadurch gekennzeichnet,**
**dass** die Modul-Vorderwände (30) gemeinsam eine die gesamte Trägerstruktur (14) abdeckende Abdeckfläche bilden.

10. Gravimetrische Messvorrichtung nach einem der vorangehenden Ansprüche,
**dadurch gekennzeichnet,**
**dass** die Modul-Vorderwände (30) gemeinsam eine ebene Abdeckfläche bilden.

11. Gravimetrische Messvorrichtung nach einem der vorangehenden Ansprüche,
**dadurch gekennzeichnet,**
**dass** wenigstens eines der Abdeckmodule (28) einen trägerstrukturseitigen Leerraum abdeckt, in dem eine elektronische Primäreinheit angeordnet und an der Trägerstruktur (14) fixiert ist.

12. Gravimetrische Messvorrichtung nach Anspruch 11,
**dadurch gekennzeichnet,**
**dass** die Modul-Vorderwand des die elektronische Primäreinheit abdeckenden Abdeckmoduls eine mit dieser verbundene Sekundäreinheit trägt.

13. Gravimetrische Messvorrichtung nach einem der vorangehenden Ansprüche,
**dadurch gekennzeichnet,**
**dass** die Modul-Vorderwand wenigstens eines Abdeckmoduls eine in den Wägeraum ragende Funktionseinheit trägt.

## Claims

1. Gravimetric measuring device, comprising a weighing chamber having a vertical weighing chamber wall which is designed as a support structure (14) with cover modules (28) which are detachably fastened thereto on the weighing chamber side and which each comprise a module front wall (30) on the weighing chamber side and cover the support structure (14) at least in regions,
wherein the cover modules (28) have locking cantilevers (38) directed towards the support structure,
**characterized in that**
the locking cantilevers (38) are provided with vertically oriented through-openings (40) which align with corresponding openings (20, 22) of the support structure (14), wherein the cover modules (28) are locked to the support structure (14) by means of locking rods (42) which penetrate the mutually aligned openings (40; 20, 22) of the cover modules (28) and of the support structure (14).

2. Gravimetric measuring device according to claim 1,
**characterized in that**
the locking rods (42) penetrate the mutually aligned openings (40; 20, 22) with a form fit.

3. Gravimetric measuring device according to any one of the preceding claims,
**characterized in that**
the cover modules (28) each have pre-fastening cantilevers (46) directed towards the support structure, the pre-fastening cantilevers having latching elements (44) on the module side, which are reversibly latched to corresponding latching elements (26) on the support structure.

4. Gravimetric measuring device according to claim 3,
**characterized in that**
in each case two pairs of latching elements (26, 44) which are latched to each other form an articulation of the respective cover module (28) on the support structure (14), said articulation being pivotable about a horizontal pivot axis that is parallel to the wall.

5. Gravimetric measuring device according to any one of claims 3 to 4,
**characterized in that**
the latching elements (26) on the support structure are designed as laterally displaceable, spring-loaded ball elements, and the latching elements (44) on the module are designed as corresponding sockets.

6. Gravimetric measuring device according to any one of the preceding claims,
**characterized in that**
the cover modules (28) have module edge walls (32, 34, 36) which extend from the respective module front wall (30) towards the support structure and are oriented perpendicular to the module front wall (30).

7. Gravimetric measuring device according to claim 6,
**characterized in that**
the module edge walls (32, 34, 36) comprise a lower module wall (36) on a bottom side and an upper module wall (34) arranged opposite thereto, and the locking cantilevers (38) are designed as tabs arranged at the free edge of the upper and lower module wall (34, 36) .

8. Gravimetric measuring device according to any one of claims 6 to 7,
**characterized in that**
the module edge walls (32, 34, 36) comprise two vertically oriented module side walls (32), and the pre-fastening cantilevers (46) are designed as tabs arranged at the free edge of the module side walls (32).

9. Gravimetric measuring device according to any one of the preceding claims,
**characterized in that**
the module front walls (30) together form a covering surface which covers the entire support structure (14).

10. Gravimetric measuring device according to any one of the preceding claims,
**characterized in that**
the module front walls (30) together form a flat covering surface.

11. Gravimetric measuring device according to any one of the preceding claims,
**characterized in that**
at least one of the cover modules (28) covers an empty space on the support structure, in which an electronic primary unit is arranged and is fastened to the support structure (14).

12. Gravimetric measuring device according to claim 11,
**characterized in that**
the module front wall of the cover module that covers the electronic primary unit bears a secondary unit, which is connected to the primary unit.

13. Gravimetric measuring device according to any one of the preceding claims,
**characterized in that**
the module front wall of at least one cover module bears a functional unit, which projects into the weighing chamber.

## Revendications

1. Dispositif de mesure gravimétrique, comprenant une chambre de pesée avec une paroi de chambre de pesée verticale qui est conçue en tant que structure porteuse (14) avec des modules de recouvrement (28) fixés de façon amovible contre celle-ci côté chambre de pesée, comprenant respectivement une paroi avant de module (30) côté chambre de pesée, recouvrant la structure porteuse (14) au moins par endroits,
dans lequel les modules de recouvrement (28) présentent des avancées de verrouillage (38) orientées vers le côté structure porteuse,
**caractérisé en ce que**
les avancées de verrouillage (38) sont dotées d'ouvertures traversantes (40) orientées à la verticale, qui sont alignées avec des ouvertures (20, 22) correspondantes de la structure porteuse (14), dans lequel les modules de recouvrement (28) sont verrouillés contre la structure porteuse (14) au moyen de tiges de verrouillage (42) qui traversent les ouvertures (40; 20, 22) alignées les unes avec les autres des modules de recouvrement (28) et de la structure porteuse (14).

2. Dispositif de mesure gravimétrique selon la revendication 1,
**caractérisé en ce que**
les tiges de verrouillage (42) traversent par liaison de forme les ouvertures (40; 20, 22) alignées les unes avec les autres.

3. Dispositif de mesure gravimétrique selon l'une des revendications précédentes,
**caractérisé en ce que**
les modules de recouvrement (28) présentent respectivement des avancées de préfixation (46) orientées vers le côté structure porteuse avec des éléments d'encliquetage (44) côté module, lesquels sont encliquetés de façon réversible avec des éléments d'encliquetage (26) correspondants de la structure porteuse.

4. Dispositif de mesure gravimétrique selon la revendication 3,
**caractérisé en ce que**
respectivement deux paires d'éléments d'encliquetage (26, 44) encliquetés les uns avec les autres forment une articulation, en mouvement pivotant autour d'un axe de pivotement horizontal et parallèle à la paroi, du module de recouvrement (28) respectif contre la structure porteuse (14).

5. Dispositif de mesure gravimétrique selon l'une des revendications 3 à 4,
**caractérisé en ce que**
les éléments d'encliquetage (26) côté structure porteuse sont conçus en tant qu'éléments sphériques précontraints par ressort et coulissant latéralement et les éléments d'encliquetage (44) côté module sont conçus en tant que cavités articulaires correspondantes.

6. Dispositif de mesure gravimétrique selon l'une des revendications précédentes,
**caractérisé en ce que**
les modules de recouvrement (28) présentent des parois de bord de module (32, 34, 36) s'étendant depuis la paroi avant de module (30) respective vers le côté structure porteuse et orientées perpendiculairement à la paroi avant de module (30).

7. Dispositif de mesure gravimétrique selon la revendication 6,
**caractérisé en ce que**
les parois de bord de module (32, 34, 36) comprennent une paroi de module inférieure (36) côté fond et une paroi de module supérieure (34) agencée à l'opposé de celle-ci et les avancées de verrouillage (38) sont conçues en tant que brides agencées contre le bord libre de la paroi de module supérieure et inférieure (34, 36).

8. Dispositif de mesure gravimétrique selon l'une des revendications 6 à 7,
**caractérisé en ce que**
les parois de bord de module (32, 34, 36) comprennent deux parois latérales de module (32) orientées à la verticale et les avancées de préfixation (46) sont conçues en tant que brides agencées contre le bord libre des parois latérales de module (32).

9. Dispositif de mesure gravimétrique selon l'une des revendications précédentes,
**caractérisé en ce que**
les parois avant de module (30) forment ensemble une surface de recouvrement recouvrant la totalité de la structure porteuse (14).

10. Dispositif de mesure gravimétrique selon l'une des revendications précédentes,
**caractérisé en ce que**
les parois avant de module (30) forment ensemble une surface de recouvrement plane.

11. Dispositif de mesure gravimétrique selon l'une des revendications précédentes,
**caractérisé en ce que**
au moins l'un des modules de recouvrement (28) recouvre un espace vide côté structure porteuse, dans lequel une unité primaire électronique est agencée et fixée contre la structure porteuse (14).

12. Dispositif de mesure gravimétrique selon la revendication 11,
**caractérisé en ce que**
la paroi avant de module du module de recouvrement recouvrant l'unité primaire électronique porte une unité secondaire reliée à celle-ci.

13. Dispositif de mesure gravimétrique selon l'une des revendications précédentes,
**caractérisé en ce que**
la paroi avant de module d'au moins un module de recouvrement porte une unité fonctionnelle faisant saillie jusque dans la chambre de pesée.
